# EUROPEAN PATENT APPLICATION

(11) **EP 4 847 810 A2**
(43) Date of publication of application: **02.12.2026**
(21) Application number: 26167343.8
(22) Date of filing: 24.03.2026
(51) Int. Cl.: F16K 11/22, F16K 5/06, F16K 11/20, F16K 27/00, F16K 27/06, F16K 31/60, H05K 7/20

(54) **LOW REFRIGERANT LOSS DISTRIBUTION MANIFOLD FOR LIQUID COOLING OF SERVER RACK**

(30) Priority: 26.03.2025 US 202563777859 P
(71) Applicant: Carrier Corporation, Palm Beach Gardens, FL 33418 (US)
(72) Inventor: STARK, Michael, Charlotte, 28269 (US); D'ABRUZZO, Karina, Charlotte, 28269 (US)
(74) Representative: Dehns

(57) **Abstract**

A valve assembly (100) for use in a rack cooling circuit (64) includes a valve body (102) having a first end (104), a second end (106), and a primary channel (108) arranged within an interior of the valve body (102) and extending between the first end (104) and the second end (106). A first valve (110) is associated with the valve body (102) and is operable to control a flow through the valve body (102) along the primary channel (108). A secondary channel (122) is arranged within the interior of the valve body (102). The secondary channel (122) is arranged at a non-parallel angle relative to the primary channel (108). An upstream end of the secondary channel (122) is fluidly connected to the primary channel (108) at a location downstream from the first valve (110). A second valve (120) is associated with the valve body and is operable to control a flow through the secondary channel.

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausted from the enclosure, mixes with the ambient air. An air conditioner is then used to cool the heated air of the data center and to recirculate it, repeating the cooling process.

Higher performance server components typically dissipate more power. However, the amount of heat that a conventional air-cooled cooling system can remove from a server is in part limited by the extent of the air flow available and air proprieties relative to heat transfer capacity of the air. To increase the power density of a cooling system, liquid cooling is required. Liquid cooling allows significant increase of dissipated heat from servers.

Managing the use of refrigerant in server cooling systems involves minimizing refrigerant loss and air contamination during disconnection. Current systems often have high leak rates, inefficient isolation, and require lengthy maintenance, which can reduce system efficiency and uptime. Effective refrigerant management is needed to maintain optimal cooling performance and ensure reliable operation of server systems.

### SUMMARY

According to an aspect of the invention, a valve assembly for use in a rack cooling circuit includes a valve body having a first end, a second end, and a primary channel arranged within an interior of the valve body and extending between the first end and the second end. A first valve (e.g., a supply valve according to any of the aspects or embodiments of the rack cooling circuit described herein) is associated with the valve body and is operable to control a flow through the valve body along the primary channel. A secondary channel is arranged within the interior of the valve body. The secondary channel is arranged (e.g. extends) at a non-parallel angle relative to the primary channel. An upstream end of the secondary channel is fluidly connected to the primary channel at a location downstream from the first valve. A second valve (e.g., a valve) is associated with the valve body and is operable to control a flow through the secondary channel.

In any of the aspects or embodiments described above or herein, the first valve may include a valve disc rotatable about an axis between a first orientation and a second orientation.

In any of the aspects or embodiments described above or herein, the valve disc may comprise or be a valve ball having an opening. An axis of the opening may be coaxial with the primary channel when the valve disc is in the first orientation and the axis of the opening may be arranged at a non-parallel angle relative to the primary channel when the valve disc is in the second orientation.

In any of the aspects or embodiments described above or herein, the second valve may include an interchangeable valve core.

In any of the aspects or embodiments described above or herein, the second valve may include a (or the) valve core and a biasing mechanism operably coupled to the valve core to bias the valve core to a closed position.

In any of the aspects or embodiments described above or herein, the second valve may be transformable to an open position in response to application of a force to the valve core opposing the bias of the biasing mechanism.

In any of the aspects or embodiments described above or herein, a cap may be selectively connectable to the valve body proximate an end of the secondary channel to seal the end of the secondary channel.

According to another aspect of the invention, a rack cooling circuit for cooling at least one server includes a supply manifold, a supply conduit fluidly connecting the supply manifold to the at least one server, a return manifold, and a return conduit fluidly connecting the return manifold to the at least one server. A supply valve is operable to control a flow of working fluid from the supply manifold to the at least one server via the supply conduit. A return valve is operable to control a flow of working fluid from the supply manifold to the at least one server via the supply conduit. A valve is fluidly connected to the rack cooling circuit downstream from the supply valve and upstream from the return valve. The valve is operable to drain cooling medium from the rack cooling circuit.

According to another aspect of the invention, a rack cooling circuit for cooling at least one server includes a supply manifold, a supply conduit fluidly connecting the supply manifold to the at least one server, a return manifold, and a return conduit fluidly connecting the return manifold to the at least one server. A supply valve is operable to control a flow of working fluid from the supply manifold to the at least one server via the supply conduit. A return valve is operable to control a flow of working fluid to the return manifold from the at least one server via the return conduit. A valve is fluidly connected to the rack cooling circuit downstream from the supply valve and upstream from the return valve. The valve is operable to drain cooling medium from the rack cooling circuit.

In any of the aspects or embodiments described above or herein, at least one of the supply conduit and the return conduit may be fluidly connected to the at least one server via a quick connector.

In any of the aspects or embodiments described above or herein, at least one of the supply conduit may be fluidly connected to the supply valve and/or the return conduit may be fluidly connected to the return valve via a quick connector.

In any of the aspects or embodiments described above or herein, the valve and one of the supply valve and the return valve may be integrally formed as a valve assembly (e.g., a valve assembly according to any of the aspects or embodiments of the valve assembly described above).

In any of the aspects or embodiments described above or herein, the valve assembly may comprise a valve body having a first end, a second end, and a primary channel arranged within an interior of the valve body and extending between the first end and the second end. The supply valve (e.g., the first valve) may be arranged within an interior of the valve body and is movable to control a flow through the valve body along the primary channel. A secondary channel may be arranged within an interior of the valve body at a non-parallel angle relative to the primary channel. An upstream end of the secondary channel may be fluidly connected to the primary channel at a location downstream from the supply valve. The valve (e.g., the second valve) may be arranged within an interior of the valve body and is operable to control a flow through the secondary channel.

In any of the aspects or embodiments described above or herein, the supply valve may include a valve ball having an opening. An axis of the opening may be coaxial with the primary channel when the supply valve is open and the axis of the opening may be arranged at a non-parallel angle relative to the primary channel when the supply valve is closed.

In any of the aspects or embodiments described above or herein, the valve may include an interchangeable valve core.

In any of the aspects or embodiments described above or herein, the valve may include a (or the) valve core and a biasing mechanism operably coupled to the valve core to bias the valve core to a closed position.

In any of the aspects or embodiments described above or herein, a device may be connectable to a distal end of the secondary channel to open the valve. The device may include a conduit fluidly connecting the secondary channel to another portion of the rack cooling circuit.

According to another aspect of the invention, a method of isolating a server from a rack cooling circuit is provided. The method includes closing a supply valve arranged upstream from the server to stop a supply of working fluid to the server, closing a return valve arranged downstream from the server to stop a flow of working fluid from the server, operating a valve to drain a working fluid from a portion of the rack cooling circuit downstream from the supply valve and upstream from the return valve, and operating at least one quick connector to separate the server from the rack cooling circuit.

In any of the aspects or embodiments described above or herein, operating at least one quick connector to separate the server from the rack cooling circuit may include operating at least one quick connector to separate the server from a supply conduit and a return conduit of the rack cooling circuit.

In any of the aspects or embodiments described above or herein, operating at least one quick connector to separate the server from the rack cooling circuit may include operating at least one quick connector to separate a supply conduit fluidly connected to the server from the supply valve and to separate a return conduit fluidly connected to the server from the return valve.

In any of the aspects or embodiments described above or herein, operating the valve to drain the working fluid from a portion of the rack cooling circuit downstream from the supply valve and upstream from the return valve may include connecting a device including a conduit to the valve and draining the working fluid to another portion of the rack cooling circuit.

In any of the aspects or embodiments described above or herein, the method may include removing non-condensable material from the portion of the rack cooling circuit downstream from the supply valve and upstream from the return valve.

### BRIEF DESCRIPTION OF THE DRAWINGS

The following descriptions should not be considered limiting in any way. Certain exemplary embodiments will now be described in greater detail by way of example only and with reference to the accompanying drawings, in which like elements are numbered alike:
FIG. 1 is a schematic diagram of an example of a cooling system;
FIG. 2 is a detailed schematic diagram of a plurality of servers within a rack system;
FIG. 3 is a detailed view of a server of a rack system fluidly connected to a rack cooling circuit;
FIG. 4A is a partial cross-sectional view of a valve assembly of a rack cooling system when the first valve is in a first orientation;
FIG. 4B is a partial cross-sectional view of the valve assembly of FIG. 4A when the first valve is in a second orientation; and
FIG. 4C is a partial cross-sectional view of a valve assembly including a first valve and a second valve.

### DETAILED DESCRIPTION

A detailed description of one or more embodiments of the disclosed apparatus and method are presented herein by way of exemplification and not limitation with reference to the Figures.

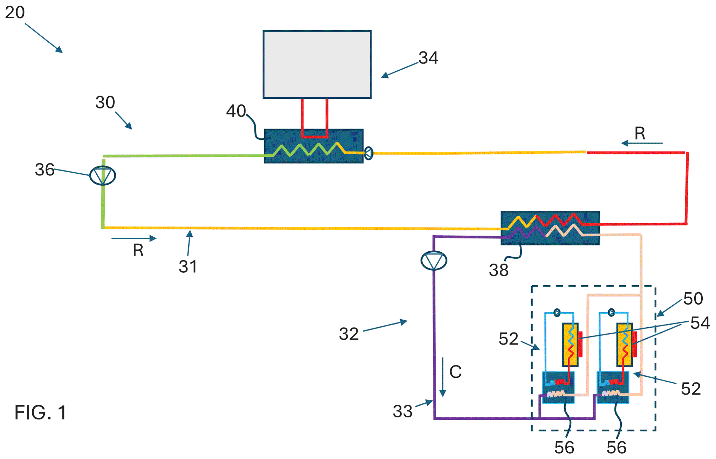

Referring to FIG. 1, an example of a cooling system 20 is illustrated. As shown, the cooling system 20 includes a first cooling system 30 and a plurality of loads thermally coupled to the first cooling system 30. As used herein, the term "load" is intended to apply to any secondary system or component that is thermally coupled to the first cooling system 30, regardless of whether the secondary system or component is configured to transfer heat to the first cooling system 30 or remove heat from the first cooling system 30. In the illustrated, non-limiting embodiment, the plurality of loads of the first cooling system 30 includes a first load 32 and a second load 34. However, it should be appreciated that embodiments having any number of loads connected to the first cooling system 30, such as three loads, four loads, or five loads for example, are within the disclosure. Examples of suitable loads include but are not limited to a data center cooling system, an air conditioning system such as an air handling unit, a chiller system, a heat pump, and a sanitary or potable water system.

As shown, the first cooling system 30 includes a primary cooling circuit 31 through which a primary heat transfer fluid R circulates. Examples of suitable heat transfer fluids R include but are not limited to water, propylene glycol, ethylene glycol, dielectric fluid, and refrigerant. The first cooling system 30 may include a pump or other movement device 36 for moving the heat transfer fluid R through the primary cooling circuit 31. In some embodiments, the primary cooling circuit 31 may include one or more valves (not shown), such as to allow the heat transfer fluid R to selectively bypass one or more of the loads. Although the primary cooling circuit 31 is illustrated as having a closed loop configuration, embodiments where the primary cooling circuit 31 is not a closed loop are also contemplated herein.

The first cooling system 30 is configured to transfer heat between the plurality of loads. In the simplified first cooling system 30 illustrated in the embodiment of FIG. 1, the heat transfer fluid R is configured to absorb heat from the first load 32 and transfer heat to the second load 34. Although the primary cooling circuit 31 is illustrated as being thermally coupled to one or more loads via heat exchangers, such as a first heat exchanger 38 and a second heat exchanger 40, respectively, it should be appreciated that embodiments where the primary cooling circuit 31 is thermally coupled to the at least one load in another suitable manner are within the scope of the disclosure.

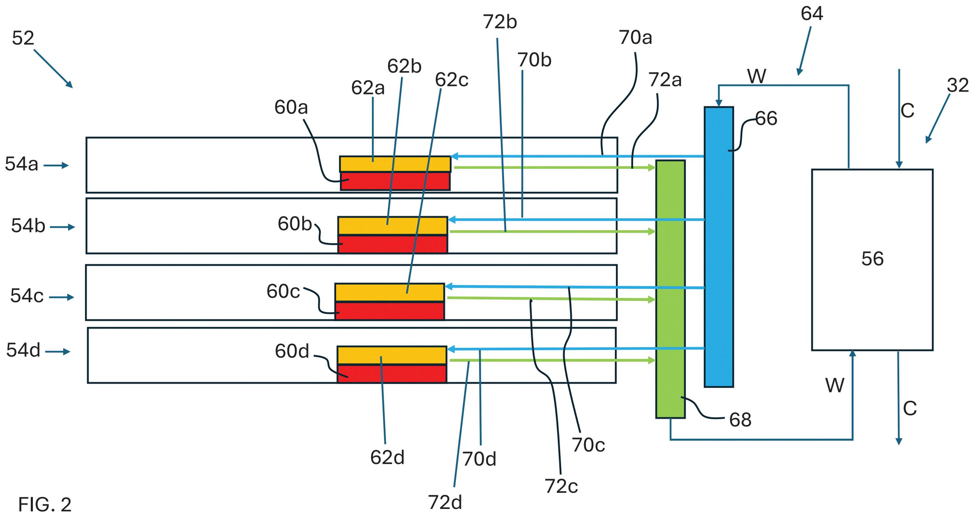

In the illustrated, non-limiting embodiment, the first load 32 is a second cooling system, such as a data center cooling system for example, and includes a secondary cooling circuit 33 through which a coolant or secondary cooling fluid C is configured to circulate. In some embodiments, the coolant C is a liquid, such as water, propylene glycol, or dielectric fluid for example. The second cooling system 32 is associated with one or more data centers server rack 50, each having at least one rack system 52 containing at least one server or assembly having heat-generating electronic devices (referred to herein as "servers") therein (see FIG. 2). As shown, the rack system 52 includes at least one heat recovery component 56 configured to receive a flow of the coolant C. In the illustrated, non-limiting embodiment, the heat recovery component 56 is a heat exchanger. However, in other embodiments the heat recovery component 56 may be a cold plate or other suitable heat transfer device. Within each heat recovery component 56, heat is transferred from the rack system 52, such as from the one or more components of the at least one server 54 arranged therein, to the coolant C. In embodiments where a data center 50 includes a plurality of rack systems 52, as shown in FIG. 1, the coolant C may be provided to the heat recovery component 56 associated with each rack system 52, or the individual servers 54 thereof, in parallel. The flows of coolant C output from each heat recovery component 56 are then rejoined at a location upstream from the first heat exchanger 38 or other thermal coupling with the first cooling system 30. It should be appreciated that in embodiments wherein the second cooling system 32 alternatively or additionally includes a plurality of data centers 50, the coolant C may be provided to each data center server rack 50 in parallel, and further may be provided to the heat recovery component 56 of each rack system 52 of the plurality of data centers 50 in parallel.

With reference now to FIG. 2, a detailed view of an interface between the second cooling system 32 and a rack system 52 is illustrated in more detail. In the illustrated, non-limiting embodiment, the rack system 52 includes four servers 54a, 54b 54c, 54d, each having at least one heat-generating electrical device, such as a central processing unit, or a graphical processing unit, represented at 60a, 60b, 60c, 60d, that generates heat. In the illustrated, non-limiting embodiment, a heat transfer element 62a, 62b, 62c, 62d, such as a cold plate or heat exchanger for example, is thermally coupled to the at least one heat-generating electrical devices 60a, 60b, 60c, 60d of each server 54a, 54b, 54c, 54d.

A closed loop, rack cooling circuit 64 is fluidly connected to each server 54a, 54b 54c, 54d within the rack system 52 in parallel. As shown, a working fluid W is configured to circulate through the rack cooling circuit 64. In an embodiment, the working fluid W is a refrigerant. However, embodiments where the working fluid W is another suitable fluid, such as water, or propylene glycol, for example, are also within the scope of the disclosure. The rack cooling circuit 64 may include a supply manifold 66 and a return manifold 68 fluidly connected to the one or more heat transfer elements 62a, 62b, 62c, 62d of each server 54a, 54b, 54c, 54d. In the illustrated, non-limiting embodiment, each server 54a, 54b, 54c, 54d is fluidly connected to the supply manifold 66 and the return manifold 68 in parallel. A supply conduit 70a, 70b, 70c, 70d may extend from the supply manifold 66 to the one or more heat transfer elements 62a, 62b, 62c, 62d of each server 54a, 54b, 54c, 54d, and a return conduit 72a, 72b, 72c, 72d may extend from the one or more heat transfer elements 62a, 62b, 62c, 62d of each server 54a, 54b, 54c, 54d to the return manifold 68.

Each first fluid conduit or supply conduit 70a, 70b, 70c, 70d of the rack cooling circuit 64 is configured to receive cool working fluid from the supply manifold 66 and deliver it to the at least one heat transfer element 62a, 62b, 62c, 62d of a respective server 54a, 54b, 54c, 54d. The second fluid conduit or return conduit 72a, 72b, 72c, 72d receives heated working fluid W from at least one the heat transfer element 62a, 62b, 62c, 62d coupled to at least one heat-generating electrical component 60a, 60b, 60c, 60d of a server 54a, 54b, 54c, 54d and deliver it to the return manifold 68. In an embodiment, the working fluid W provided to return manifold 68 is a two-phase mixture of liquid and vapor; however, embodiments where the working fluid W is a single phase are also within contemplated herein. In some embodiments, the working fluid W provided to the return manifold 68 is a superheated vapor. The heated working fluid W output from the return manifold 68 is provided to an inlet of the heat recovery component 56. Within the heat recovery component 56, the cold coolant C acts as a heat sink to absorb heat from the working fluid W. As a result, a cool working fluid W is output from an outlet of the heat recovery component 56 and is returned to an inlet of the supply manifold 66 to repeat the cycle.

The working fluid W may be circulated through the closed loop of the rack cooling circuit 64 in any suitable manner. In some embodiments, the rack cooling circuit 64 includes a pump (not shown) operable to circulate the working fluid W therethrough. In other embodiments, the rack cooling circuit 64 may be configured as a thermosiphon that uses heat transfer to the working fluid W via at least one heat transfer element 62a, 62b, 62c, 62d to move the working fluid W to the return manifold 68 without the use of a mechanical pump.

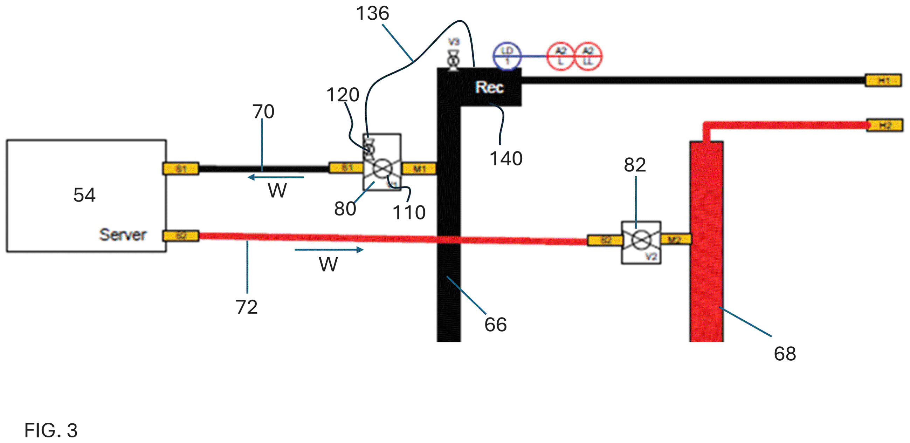

With reference now to FIG. 3, an exemplary connection between a server 54 and the supply manifold 66 and return manifold 68 of the rack cooling circuit 64 is illustrated in more detail. It should be appreciated that the server 54 illustrated and described with respect to FIG. 3 is intended to be representative of any of the servers, such as servers 54a, 54b, 54c, 54d of the rack system 52. In the illustrated, non-limiting embodiment, a supply valve 80 is associated with and is operable to control a flow from the supply manifold 66 through the supply conduit 70 and a return valve 82 is associated with and is operable to control a flow through the return conduit 72 to the return manifold 68. As shown, the supply valve 80 may be arranged at the supply conduit 70, such as at or proximate an interface between the supply manifold and the supply conduit 70 for example. Alternatively, or in addition, the return valve 82 may be located at the return conduit 72, such as at an interface between the return conduit 72 and the return manifold 68 for example. However, it should be understood that embodiments where the supply valve 80 and/or return valve 82 are arranged at another suitable location along the supply conduit 70 or the return conduit 72 are also contemplated herein. Further, embodiments where the supply valve 80 is integrated into the supply manifold 66 and/or where the return valve 82 is integrated into the return manifold 68 are also within the scope of the disclosure. The supply valve 80 and the return valve 82 may be substantially identical or may be different.

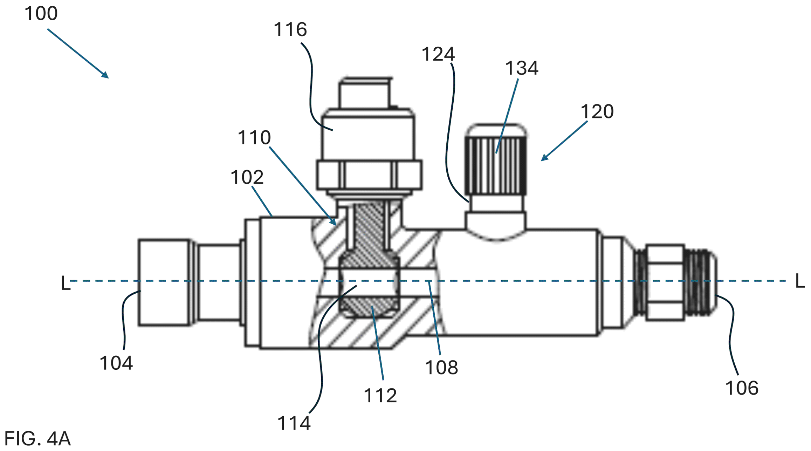

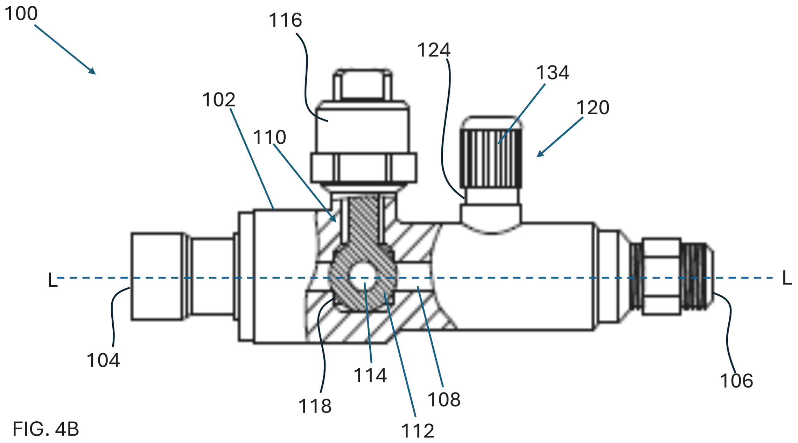

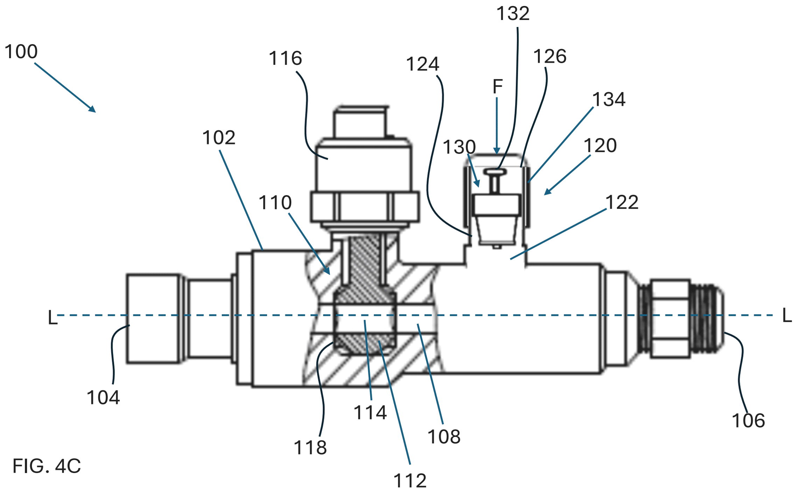

With reference now to FIGS. 4A, 4B, 4C, an example of a valve assembly 100 suitable for use in the rack cooling circuit 64 is illustrated. It should be understood that one or both of the supply valve 80 and the return valve 82 may be configured as the valve assembly 100 illustrated and described herein. However, embodiments where one or both of the supply valve 80 and the return valve 82 have a different configuration are also contemplated herein. In an embodiment, the valve assembly 100 includes a positive sealing isolation valve.

As shown, the valve assembly 100 includes a valve body 102 having a first end 104, a second end 106, and an internal primary channel 108 extending between the opposing first and second ends 104, 106 of the valve body 102. In an embodiment, the first end 104 of each valve assembly 100 installed within the rack cooling circuit 64 is positioned closest to a manifold 66, 68. Accordingly, with respect to the supply valve 80 within the supply conduit 70, the first end 104 is an upstream end and the second end 106 is the downstream end relative to a flow of the working fluid W and with respect to the return valve 82 within return conduit 72, the second end 106 may be the upstream end and the first end 104 is the downstream end relative to a flow of the working fluid W.

In an embodiment, the primary channel 108 has an axial configuration, parallel to the longitudinal axis L of the valve body 102. The valve assembly 100 includes at least one valve 110 operable to control a flow through the valve body 102. As shown, a first valve may include a valve disc 112 rotatably mounted within the primary channel 108. In the illustrated, non-limiting embodiment, the valve disc 112 is a valve ball having an opening 114 formed therein. However, it should be understood that a valve assembly 100 having a valve disc 112 with another configuration is also within the scope of the disclosure.

The valve disc 112 is rotatable between a first orientation (FIG. 4A) and a second orientation (FIG. 4B), such as via an actuator or other suitable mechanism, represented generally at 116. In the first orientation (FIG. 4A), the opening 114 is coaxial or aligned with the primary channel 108 and the longitudinal axis L of the valve body 102. In the second orientation (FIG. 4B), the opening 114 is arranged at a non-parallel angle relative to the primary channel 108, and/or the longitudinal axis L of the valve body 102. In an embodiment, the valve disc 112 is oriented perpendicular to the primary channel 108 and the longitudinal axis L when in the second position.

The first valve 110, including the valve disc 112, may be considered in a fully open position, allowing a maximum flow through the valve body 102 via the opening 114, when the valve disc 112 is in the first orientation (FIG. 4A). When the valve disc 112 is in the second orientation (FIG. 4B), the first valve 110 may be considered to be in a fully closed position. When the valve disc 112 is in this second position, the primary channel 108 is sealed by the interface between the valve disc 112 and a portion of the valve body 102. Further, because the opening 114 of the valve disc 112 is oriented perpendicularly to the primary channel 108, when the valve disc 112 is in the second position, no flow is configured to pass through the opening 114 or the primary channel 108. In an embodiment, the valve seat 118, arranged at the valve body 102 adjacent to the downstream side of the valve disc 112 relative to the flow through the valve body 102, includes an O-ring operable to form a seal against the surface of the valve disc 112 when the valve disc 112 is in the second orientation.

In addition to the first valve 110 operable to control a flow of a working fluid W through the valve body 102 via the primary channel 108, in an embodiment, the valve assembly 100 additionally includes a second valve 120. The second valve 120 may be associated with and operable to control a flow through a secondary channel 122 (see FIG. 4C) formed in the valve body 102. In the illustrated, non-limiting embodiment, at least one sidewall 124 protrudes from a periphery of the valve body 102 at a non-parallel angle relative to the primary channel 108 and/or the longitudinal axis L. As shown, the secondary channel 122 defined by the at least one sidewall 124 may be oriented generally orthogonal or perpendicular to the primary channel 108. In an embodiment, an upstream end of the secondary channel 122 is fluidly coupled to primary channel 108, such as at a location downstream from the valve disc 112 for example. The second, downstream end of the secondary channel 122 may be arranged at the distal end 126 of the at least one sidewall 124. As shown in FIG. 4C, at the distal end 126, the secondary channel 122 is fluidly connected to the ambient atmosphere surrounding an exterior of the valve body 102 and the at least one sidewall 124.

With continued reference to FIG. 4C, a valve core 130 may be arranged within the secondary channel 122. In an embodiment, the valve core 130 is a springloaded poppet valve or a Schrader valve. However, it should be understood that the valve core 130 of second valve 120 may be interchangeable and therefore have a different configuration. Application of a force F to an exposed end 132 of the valve core 130 in a direction opposite the biasing mechanism operably coupled thereto, such as in a direction toward an interior of the valve body 102 for example, is operable to open the second valve 120. Upon removal of the force F, the biasing force of the biasing mechanism will return the valve core 130 to a neutral position. When the valve core 130 is in the open position, fluid within the primary channel 108 is operable to pass through the valve core 130 within the secondary channel 122. The fluid configured to pass through the valve core 130 when opened may be vapor, a liquid, or a mixture thereof.

A cap 134 may be removably connected to the valve body 102 proximate the distal end 126 of the at least one sidewall 124 and the secondary channel 122 to prevent inadvertent opening of the valve core 130. In an embodiment, the exterior of the valve body 102 proximate the distal end 126 of the at least one sidewall 124 includes a plurality of threads, and the cap 134 has a plurality of complementary threads engageable therewith to couple the cap 134 to the valve body 102. When the cap 134 is separated from the at least one sidewall 124, a device connectable to the distal end 126 and configured to apply a force to, and therefore open the valve core 130, may also fluidly couple the second valve 120 to an upstream portion of the rack cooling circuit 64. For example, the rack cooling circuit 64 may include a receiver 140, and the working fluid W expelled via the second valve 120 may be provided directly to the receiver 140 via a conduit 136.

As previously noted, one or both of the supply valve 80 and the return valve 82 has a configuration matching that of the valve assembly 100 described above. In such embodiments, the end of each valve closest to a manifold, such as the upstream end 104 of the supply valve 80 and the downstream end of the return valve 82 for example, may be fluidly coupled to the adjacent manifold via a leak-tight brazed connection. To decouple a server from the rack cooling circuit 64, the supply valve 80 associated with the first conduit 70 and the return valve 82 associated with the return conduit 72 are closed. For example, the first valve 110 of the supply valve 80 and the first valve 110 of the return valve 82 may be closed in series. In an embodiment, the first valve 110 of the supply valve 80 is closed prior to closing the first valve 110 of the return valve 82. By allowing the return valve 82 to remain open, even briefly, after closing the upstream first valve 110, the operation of a pump or other movement mechanism to circulate the flow through the rack cooling circuit 64 may aid in drawing the working fluid W from downstream of the supply valve 80.

Once both the supply valve 80 and the return valve 82 are closed, any remaining working fluid W within the rack cooling circuit 64 between the supply valve 80 and the return valve 82 may be drained. To drain the cooling fluid, the cap 134 may be removed from the second valve 120 of the supply valve 80. A draining conduit may be connected to the second valve 120 to recirculate any of the working fluid W output therefrom to another portion of the rack cooling circuit 64. In embodiments where the working fluid W being removed via the second valve 120 includes a liquid, a suction pump or vacuum may act on the secondary channel 122 to draw the liquid therethrough. In some embodiments, the suction pump may draw a vacuum to remove non-condensable matter or fluid, such as air for example, from the system in preparation to return the working fluid W to the portion of the rack cooling circuit 64 between the supply valve 80 and the return valve 82.

Once the working fluid W is removed from the rack cooling circuit 64 between the supply valve 80 and the return valve 82, the server 54 may be decoupled from the rack cooling circuit 64. In an embodiment, the server 54 is fluidly connected to at least one of the supply conduit 70 and the return conduit 72 via quick connectors. In such embodiments, the quick connectors are operated to fluidly disconnect the server 54 from the supply conduit 70 and return conduit 72. As used herein the term "quick connectors" is intended to describe a coupling or fitting that allows for a quick connection and disconnection of fluid lines and that is typically operated by hand, without the use of tools. Alternatively, or in addition, the interface between a downstream end 106 of the supply valve 80 and the supply conduit 70 and/or between an upstream end of the return valve 82 may be formed via quick connectors. In some embodiments, the server 54, the supply conduit 70, and the return conduit 72 may be fluidly disconnected from the rack cooing circuit 64 via these quick connectors.

In an embodiment, a sensor is operable to monitor a level of working fluid W within a portion of the rack cooling circuit 64, such as within the supply manifold 66 and the return manifold 68 for example. The sensor may indicate when a level of working fluid W approaches or falls below a minimum threshold. F The sensor is therefore operable to detect adverse operating conditions and generate an alert that service is required.

A rack cooling circuit 64 as illustrated and described herein allows for efficient management of the working fluid W during maintenance and/or replacement of servers 54. The isolation of the server 54 formed via the supply valve 80 and the return valve 82, in combination, minimizes the pressure drop within the circuit which lowers cooling costs and increases the system's power usage effectiveness (PUE).

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A valve assembly (100) for use in a rack cooling circuit (64), the valve assembly (100) comprising:
a valve body (102) having a first end (104), a second end (106), and a primary channel (108) arranged within an interior of the valve body (102) and extending between the first end (104) and the second end (106);
a first valve (110) associated with the valve body (102), the first valve (110) being operable to control a flow through the valve body (102) along the primary channel (108);
a secondary channel (122) arranged within an interior of the valve body (102), the secondary channel (122) being arranged at a non-parallel angle relative to the primary channel (108), wherein an upstream end of the secondary channel (122) is fluidly connected to the primary channel (108) at a location downstream from the first valve (110); and
a second valve (120) associated with the valve body (102), the second valve (120) being operable to control a flow through the secondary channel (122).

2. The valve assembly (100) of claim 1, wherein the first valve (110) includes a valve disc (112) rotatable about an axis between a first orientation and a second orientation, wherein, optionally, the valve disc (112) is a valve ball having an opening (114), an axis of the opening (114) is coaxial with the primary channel (108) when the valve disc (112) is in the first orientation and the axis of the opening (114) is arranged at a non-parallel angle relative to the primary channel (108) when the valve disc (112) is in the second orientation.

3. The valve assembly (100) of claim 1 or 2, wherein the second valve (120) includes an interchangeable valve core (130).

4. The valve assembly (100) of claim 1, 2 or- 3, wherein the second valve (120) includes a valve core (130) and a biasing mechanism operably coupled to the valve core (130) to bias the valve core (130) to a closed position.

5. The valve assembly (100) of claim 4, wherein the second valve (120) is transformable to an open position in response to application of a force to the valve core (130) opposing the bias of the biasing mechanism.

6. The valve assembly (100) of any of claims 1-5, further comprising a cap (134), the cap (134) being selectively connectable to the valve body (102) proximate an end of the secondary channel (122) to seal the end of the secondary channel (122).

7. A rack cooling circuit (64) for cooling at least one server (54, 54a-d), the rack cooling circuit (64) comprising:
a supply manifold (66);
a supply conduit (70a-d) fluidly connecting the supply manifold (66) to the at least one server (54, 54a-d);
a return manifold (68);
a return conduit (72a-d) fluidly connecting the return manifold (68) to the at least one server (54, 54a-d);
a supply valve (80) operable to control a flow of working fluid from the supply manifold (66) to the at least one server (54, 54a-d) via the supply conduit (70a-d);
a return valve (82) operable to control a flow of working fluid to the return manifold (68) from the at least one server (54, 54a-d) via the return conduit (72a-d); and
a valve (120) fluidly connected to the rack cooling circuit (64) downstream from the supply valve (80) and upstream from the return valve (82), the valve (120) being operable to drain cooling medium from the rack cooling circuit (64).

8. The rack cooling circuit (64) of claim 7, wherein:
at least one of the supply conduit (70a-d) and the return conduit (72a-d) is fluidly connected to the at least one server (54, 54a-d) via a quick connector; and/or
at least one of the supply conduit (70a) is fluidly connected to the supply valve (80) and the return conduit (72a) is fluidly connected to the return valve (82) via a quick connector.

9. The rack cooling circuit (64) of claim 7 or 8, wherein the valve (120) and one of the supply valve (80) and the return valve (82) are integrally formed as a valve assembly (100).

10. The rack cooling circuit (64) of claim 9, wherein the valve assembly (100) further comprises:
a valve body (102) having a first end (104), a second end (106), and a primary channel (108) arranged within an interior of the valve body (102) and extending between the first end (104) and the second end (106);
the supply valve (80, 110) being arranged within an interior of the valve body (102) and movable to control a flow through the valve body (102) along the primary channel (108);
a secondary channel (122) arranged within an interior of the valve body (102), the secondary channel (122) being arranged at a non-parallel angle relative to the primary channel (108), wherein an upstream end of the secondary channel (122) is fluidly connected to the primary channel (108) at a location downstream from the supply valve (80); and
the valve (120) arranged within an interior of the valve body (102) and being operable to control a flow through the secondary channel (122).

11. The rack cooling circuit (64) of claim 10, wherein:
the supply valve (80) includes a valve ball having an opening (114), an axis of the opening (114) is coaxial with the primary channel (108) when the supply valve (80) is open and the axis of the opening (114) is arranged at a non-parallel angle relative to the primary channel (108) when the supply valve (80) is closed; and/or
the valve (120) includes an interchangeable valve core (130); and/or
the valve (120) includes a valve core (130) and a biasing mechanism operably coupled to the valve core (130) to bias the valve core (130) to a closed position.

12. The rack cooling circuit (64) of claim 10 or 11, further comprising a device connectable to a distal end (126) of the secondary channel (122) to open the valve (120), the device including a conduit (136) fluidly connecting the secondary channel (122) to another portion of the rack cooling circuit (64).

13. A method of isolating a server (54, 54a-d) from a rack cooling circuit (64), the method comprising:
closing a supply valve (80) arranged upstream from the server (54, 54a-d) to stop a supply of working fluid to the server (54, 54a-d);
closing a return valve (82) arranged downstream from the server (54, 54a-d) to stop a flow of working fluid from the server (54, 54a-d);
operating a valve (120) to drain a working fluid from a portion of the rack cooling circuit (64) downstream from the supply valve (80) and upstream from the return valve (82); and
operating at least one quick connector to separate the server (54, 54a-d) from the rack cooling circuit (64).

14. The method of claim 13, wherein operating at least one quick connector to separate the server (54, 54a-d) from the rack cooling circuit (64) includes:
operating at least one quick connector to separate the server (54, 54a-d) from a supply conduit (70a-d) and a return conduit (72a-d) of the rack cooling circuit (64); and/or
operating at least one quick connector to separate a supply conduit (70a-d) fluidly connected to the server (54, 54a-d) from the supply valve (80) and to separate a return conduit (72a-d) fluidly connected to the server (54, 54a-d) from the return valve (82).

15. The method of claim 13 or 14, wherein:
operating the valve (120) to drain the working fluid from a portion of the rack cooling circuit (64) downstream from the supply valve (80) and upstream from the return valve (82) includes connecting a device including a conduit (136) to the valve (120) and draining the working fluid to another portion of the rack cooling circuit (64); and/or
the method further comprises removing non-condensable matter from the portion of the rack cooling circuit (64) downstream from the supply valve (80) and upstream from the return valve (82).
